# FASCICULE DE BREVET EUROPEEN

(11) **EP 3 284 328 B1**
(45) Date de publication et mention de la délivrance du brevet: **02.06.2021**
(21) Numéro de dépôt: 16719796.1
(22) Date de dépôt: 13.04.2016
(51) Int. Cl.: H05K 5/02, H05K 7/20

(54) **EQUIPEMENT ELECTRONIQUE**
ELEKTRONISCHE VORRICHTUNG
ELECTRONIC APPARATUS

(30) Priorité: 17.04.2015 FR 1553462
(43) Date de publication de la demande: 21.02.2018
(73) Titulaire: Sagemcom Broadband SAS, 92500 Rueil-Malmaison (FR)
(72) Inventeur: KOHN, Stéphane, 92500 Rueil Malmaison (FR); HERVOT, Christophe, 92500 Rueil Malmaison (FR); NEDELCU, Radu, 92500 Rueil Malmaison (FR)
(74) Mandataire: Lavaud, Thomas
(86) Numéro de dépôt international: PCT/EP2016/058080
(87) Numéro de publication internationale: WO 2016/166137

(56) Documents cités:
- CN-A- 101 453 861
- JP-A- 2006 227 513
- US-A1- 2006 262 497
- US-A1- 2006 291 161
- US-A1- 2010 006 259
- US-A1- 2013 094 147
- US-A1- 2015 049 438
- US-B1- 6 225 559

## Description

L'invention concerne la dissipation thermique des équipements électroniques. L'invention concerne plus particulièrement un équipement électronique comportant un boîtier comprenant un châssis conducteur thermique et un pied conducteur thermique en contact avec le châssis conducteur thermique. Le pied conducteur thermique est destiné à améliorer l'évacuation de la chaleur de l'intérieur de l'équipement électronique.

### ARRIERE PLAN DE L'INVENTION

La dissipation thermique issue du fonctionnement des composants électroniques dans un boîtier d'un équipement électronique (décodeur pour télévision, etc.) conduit à augmenter la température régnant à l'intérieur du boîtier et donc la température du boîtier lui-même.

L'augmentation de la température du boîtier est problématique parce que le boîtier ne doit pas présenter une température telle qu'un utilisateur pourrait être gêné voire blessé suite à un contact avec le boîtier. Pour ce qui concerne les parties extérieures d'un boîtier d'un équipement électronique de type décodeur qui ne sont pas destinées à être saisies ou à être touchées par l'utilisateur de manière continue, la température maximale admissible est classiquement de 95°C lorsque lesdites parties sont en matériau plastique et de 70°C lorsque lesdites parties sont en métal.

En outre, l'augmentation de la température régnant à l'intérieur du boîtier est problématique du fait de son impact sur les composants électroniques intégrés dans le boîtier.

La plupart des composants électroniques sont sensibles à la température : une température importante peut avoir des conséquences sur les performances des composants, sur les taux de panne des composants, sur la résistance des boîtiers des composants, etc.

La température maximale admissible à l'intérieur d'un boîtier d'un équipement électronique de type décodeur est classiquement de 90°C.

Une première solution s'offre aux concepteurs de cartes électroniques qui rencontrent un tel problème de température. Cette première solution consiste à utiliser des composants spécifiques capables de fonctionner plus longtemps à des températures plus importantes. L'utilisation de ces composants spécifiques est souvent très coûteuse car elle nécessite soit la conception de composants dédiés à l'application en question, soit la sélection de composants après des essais supplémentaires de qualification thermique. De plus, cette première solution ne résout pas le problème de l'augmentation de la température du boîtier lui-même.

La seconde solution, moins coûteuse, qui permet de réduire à la fois la température du boîtier et la température à l'intérieur du boîtier, consiste à améliorer l'évacuation de chaleur de l'intérieur du boîtier en recourant généralement à une ventilation forcée dans des canaux internes au boîtier de l'équipement. Une telle ventilation forcée présente cependant de nombreux inconvénients, parmi lesquels une augmentation de l'encombrement de l'équipement, une augmentation de sa consommation électrique, une augmentation du bruit produit lors de son fonctionnement, et une introduction possible de poussières pouvant dégrader les performances de la ventilation. On note de plus que la durée de vie réduite des ventilateurs ou turbines en environnement chaud peut entrainer une panne prématurée de l'équipement. Les documents US 2015/049438 A, JP 2006 227513 A et US 6 225 559 B1 montrent d'autres solutions permettant l'évacuation de chaleur de l'intérieur du boîtier.

Le document US 2013/094147 A1 montre un pied pour écran LCD comportant une base et une partie tubulaire en matériau conducteur thermique qui s'étend verticalement entre la base et le châssis de l'écran LCD, et des ailettes formées à l'intérieur de la partie tubulaire, la partie tubulaire servant à dissiper la chaleur dégagée par l'alimentation électrique placée dans la base du pied.

### OBJET DE L'INVENTION

L'invention a pour objet d'améliorer l'évacuation de chaleur de l'intérieur d'un boîtier d'un équipement électronique.

### RESUME DE L'INVENTION

En vue de la réalisation de ce but, on propose un équipement électronique comportant :
- un boîtier comprenant un châssis conducteur thermique ;
- des composants électroniques intégrés à l'intérieur du boîtier comprenant un composant électronique disposé directement en contact avec le châssis conducteur thermique,
- un pied conducteur thermique en contact avec le châssis conducteur thermique, le pied conducteur thermique comportant une base et une partie courante qui s'étend verticalement entre la base et le châssis conducteur thermique et des ailettes formées à l'intérieur de la partie courante.

Par « disposé en contact », on entend que le composant électronique est disposé par rapport au châssis de manière à ce qu'un transfert thermique par conduction puisse s'établir entre le composant électronique et le châssis. Le composant électronique est donc directement en contact avec le châssis.

Le pied conducteur thermique, en contact avec le châssis qui est lui-même en contact avec un composant électronique, permet d'améliorer l'évacuation de la chaleur dissipée par ce composant électronique. Cette amélioration de l'évacuation de la chaleur résulte de la surélévation du boîtier par le pied et de l'augmentation de la surface de conduction thermique grâce à la surface du pied qui est lui-même conducteur thermique.

### BREVE DESCRIPTION DES DESSINS

Il sera fait référence aux dessins annexés, parmi lesquels :
- les figures 1 et 2 représentent des vues en perspective d'un équipement électronique de l'invention selon un premier mode de réalisation ;
- la figure 3 représente une vue en perspective et de dessus d'un pied conducteur thermique de l'équipement électronique de l'invention selon le premier mode de réalisation ;
- la figure 4 représente une vue en perspective et de dessus d'un pied conducteur thermique d'un équipement électronique de l'invention selon un deuxième mode de réalisation ;
- la figure 5 est une échelle de température permettant d'interpréter les figures 6 à 10 ;
- les figures 6 à 8 représentent la température mesurée en différents endroits d'un équipement électronique de l'invention selon un troisième mode de réalisation ;
- les figures 9 et 10 représentent la température mesurée en différents endroits d'un pied conducteur thermique de l'équipement électronique de l'invention selon un troisième mode de réalisation de l'invention ;
- la figure 11 est une échelle de vitesse permettant d'interpréter la figure 12 ;
- la figure 12 représente la vitesse, mesurée en différents endroits de l'équipement, de l'air chaud évacué de l'intérieur de l'équipement électronique.

### DESCRIPTION DETAILLEE DE L'INVENTION

On décrit tout d'abord la structure de l'équipement électronique de l'invention.

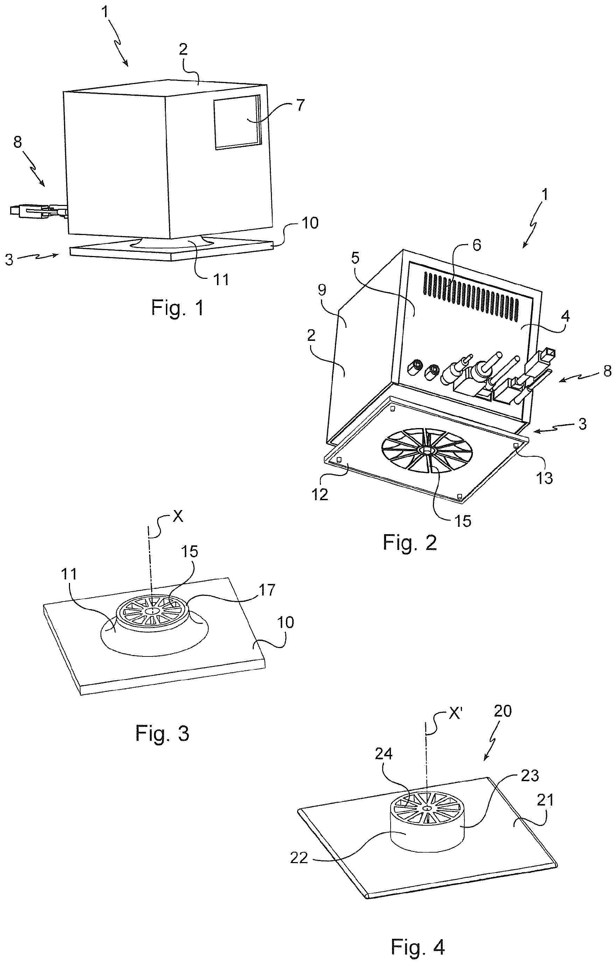

En référence aux figures 1 à 3, l'équipement électronique de l'invention selon un premier mode de réalisation est ici un décodeur 1 destiné à décrypter et à restituer des signaux de télévision.

Le décodeur 1 comporte un boitier 2, un pied conducteur thermique 3 supportant le boîtier 2, et des composants électroniques montés sur une ou plusieurs cartes électroniques disposées dans le boîtier 2.

Le boîtier 2 présente une forme générale cubique. Le boîtier 2 comporte une partie principale externe 9 en plastique et un châssis conducteur thermique 4, ici un châssis métallique, disposé à l'intérieur de la partie principale 9. Le châssis conducteur thermique 4 est en aluminium. Le châssis 4 comprend notamment une face arrière 5 du boîtier 2 qui est munie d'ouïes d'évacuation 6 destinées à évacuer la chaleur de l'intérieur du boîtier 2. Un écran d'affichage 7 ainsi qu'un certain nombre de prises 8 reliées à au moins une des cartes électroniques débouchent à l'extérieur du boîtier 2. Parmi ces prises 8, on trouve une prise électrique pour l'alimentation du décodeur 1 et des prises pour échanger des signaux divers avec d'autres équipements électroniques (prises Ethernet, HDMI, etc.).

Le pied conducteur thermique 3 est une pièce moulée, ici en aluminium, qui comprend une base 10 et une partie courante 11.

La partie courante 11 s'étend verticalement entre la base 10 et le châssis métallique 4. La partie courante 11 est délimitée par une paroi tubulaire ayant une forme de révolution d'axe X vertical et se raccordant à la base 10 en formant un congé.

La base 10 présente une forme générale plate carrée. La base 10 est destinée à être posée sur un meuble ou tout autre support quelconque portant le décodeur 1. Une face inférieure 12 de la base 10 est équipée de patins en plastique 13 pour éviter de détériorer le meuble.

A titre d'exemple, la longueur des côtés de la base 10 du pied conducteur thermique 3 est de 130 mm, l'épaisseur de la base 10 est de 7 mm, la hauteur de la partie courante 11 est de 20 mm et l'épaisseur de la paroi tubulaire formant la partie courante 11 est de 2,5 mm.

Des ailettes 15 s'étendent à l'intérieur de la partie courante 11 dans des plans radiaux par rapport à l'axe X de la partie courante 11.

La base 10 et la partie courante 11 du pied conducteur thermique 3 sont recouvertes intégralement par une enveloppe 17 en matériau thermoplastique.

A titre d'exemple, l'épaisseur de l'enveloppe plastique 17 est de 2,5 mm.

Les composants électroniques intégrés dans le boîtier 2 comportent notamment des composants d'alimentation destinés à fournir une alimentation aux composants électroniques du décodeur 1, des composants de traitement pour réaliser les fonctions de décryptage du décodeur 1, des composants de communication pour mettre en œuvre les communications entre le décodeur 1 et les autres équipements électroniques, etc.

Parmi ces composants électroniques, un composant électronique particulier, appelé ici composant électronique le plus chaud, constitue une source principale de chaleur et est disposé en contact avec le châssis 4 du boîtier 2 du décodeur 1. Le composant électronique le plus chaud est celui qui forme en fonctionnement la source de chaleur la plus importante parmi les composants électroniques du décodeur 1. Ici, ce composant est aussi le composant qui présente en fonctionnement la température au niveau de son boîtier la plus importante. Au besoin, une pâte thermiquement conductrice est interposée entre le châssis 4 et le composant pour augmenter le transfert thermique du composant électronique le plus chaud vers le châssis 4.

On note que le pied conducteur thermique 3 peut parfaitement présenter une forme différente et/ou une structure différente.

Ainsi, en référence à la figure 4, un pied conducteur thermique 20 d'un équipement électronique selon un deuxième mode de réalisation de l'invention (qui est en l'occurrence de nouveau un décodeur) comprend une base 21 et une partie courante 22 qui forment deux pièces distinctes.

La base 21 est constituée d'une plaque métallique carrée découpée. La partie courante 22 est une pièce profilée comprenant une partie tubulaire 23 et des ailettes 24 qui s'étendent à l'intérieur de la partie tubulaire 23 dans des plans radiaux par rapport à un axe X' de la partie tubulaire 23.

La base 21 et la partie courante 22 sont fixées entre elles par des moyens de fixation classiques (vissage, brasage, collage, sertissage, etc.).

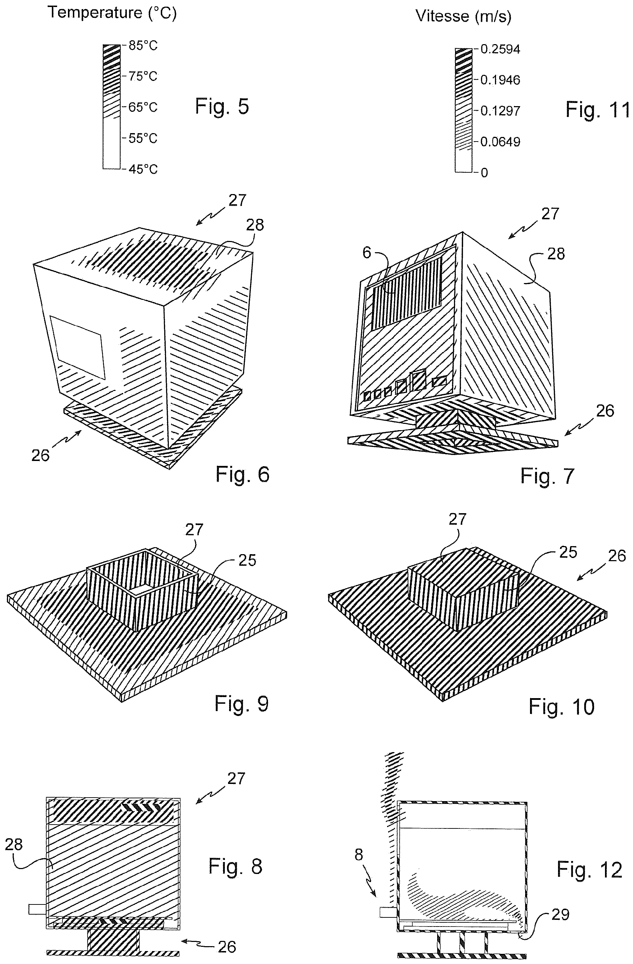

Dans un troisième mode de réalisation, visible sur les figures 6 à 10 et 12, la partie courante 25 du pied conducteur thermique 26 de l'équipement électronique ou décodeur 27 selon un troisième mode de réalisation de l'invention est un cylindre de section carrée. Dans ce cas, on ajoutera avantageusement aux moyens de fixation du pied conducteur thermique 26 au châssis précédemment évoqués une ou des butées anti-rotation permettant d'assurer que les faces de la partie courante 25 demeurent parallèles aux faces du boîtier 2 du décodeur 27.

On décrit maintenant les avantages de l'invention.

L'invention permet d'améliorer l'évacuation de chaleur de l'intérieur du boîtier 2 du décodeur 1, 27, ladite chaleur étant due à la puissance dissipée par les composants électroniques en fonctionnement, et notamment par le composant électronique le plus chaud. Cette chaleur a pour conséquence d'augmenter la température régnant à l'intérieur du boîtier 2.

L'amélioration de l'évacuation de la chaleur est due tout d'abord à la surélévation du boîtier 2 par le pied conducteur thermique 3, 20, 26 qui permet de former un passage d'air et d'augmenter le flux d'air chaud évacué. La vitesse de convection naturelle de l'air chaud évacué est multipliée par deux.

L'amélioration de l'évacuation de la chaleur est aussi due à l'augmentation de la surface de conduction thermique constituée par la surface de la partie courante et de la base du pied conducteur thermique 3, 20, 26.

Le pied conducteur thermique permet aussi d'augmenter la surface « chaude » de l'équipement électronique et favorise donc l'évacuation de la chaleur en rayonnement.

L'amélioration de l'évacuation de la chaleur est enfin due à l'augmentation de la surface de convection thermique grâce aux ailettes 15, 24.

L'ensemble de ces phénomènes permettent de réduire de 10 °C en moyenne la température de chaque élément du décodeur 1, 27.

En référence aux figures 5 à 9, et pour un équipement électronique 27 selon le troisième mode de réalisation, la température du boîtier 2 est, selon les endroits, comprise entre 65.7°C et 71.9 °C, et la température du pied est comprise entre 66 et 73.6 °C. Seule une zone localisée dans une partie supérieure de l'intérieur du boîtier 2 de l'équipement électronique 27 présente une température légèrement supérieure à 75°C. Les températures maximales évoquées plus tôt ne sont donc pas atteintes.

En référence aux figures 10 et 11, grâce à la surélévation du boîtier par le pied, la vitesse de l'air chaud évacué est relativement importante au niveau des ouïes 6 et au niveau d'un orifice 29 réalisé au niveau d'une face inférieur du boîtier 2.

Bien entendu, l'invention n'est pas limitée aux modes de réalisation décrits mais englobe toute variante entrant dans le champ de l'invention telle que définie par les revendications.

Bien que l'on ait indiqué que le pied est fabriqué en aluminium, il pourrait aussi être fabriqué dans une matière différente : acier, laiton, cuivre, zamac, etc.

Bien que les pieds qui ont été décrits ici présentent chacun une partie courante creuse, le pied de l'équipement électronique de l'invention peut parfaitement être plein.

Bien que l'on ait indiqué que la base et la partie courante du pied conducteur thermique sont recouvertes intégralement par une enveloppe plastique, il suffit que celles-ci soient couvertes au moins partiellement d'une telle enveloppe.

Bien qu'ici, le composant électronique le plus chaud soit à la fois celui qui forme en fonctionnement la source de chaleur la plus importante parmi les composants électroniques du décodeur et celui qui présente en fonctionnement la température au niveau de son boîtier la plus importante, deux composants peuvent présenter chacun l'une de ces deux caractéristiques. Dans ce cas, le composant électronique le plus chaud en contact avec le châssis sera l'un de ces deux composants (les deux composants pouvant bien sûr dans ce cas être positionnées en contact avec le châssis).

Les moyens de fixation évoqués plus tôt peuvent être remplacés par tous types de moyens de fixation appropriés. Pour fixer le pied au châssis, on pourra par exemple utiliser une fixation de type baïonnette rotative avec une butée et verrouillage final pour permettre un montage et un démontage rapide du pied.

## Revendications

1. Equipement électronique comportant :
- un boîtier (2) comprenant un châssis conducteur thermique (4) ;
- des composants électroniques intégrés à l'intérieur du boîtier (2) comprenant un composant électronique disposé directement en contact avec le châssis conducteur thermique (4).
- un pied conducteur thermique (3 ; 20 ; 26) en contact avec le châssis conducteur thermique, le pied conducteur thermique comportant une base et une partie courante qui s'étend verticalement entre la base et le châssis conducteur thermique et des ailettes formées à l'intérieur de la partie courante.

2. Equipement électronique selon la revendication 1, dans lequel le composant électronique disposé directement en contact avec le châssis conducteur thermique (4) est un composant électronique le plus chaud qui est la source de chaleur la plus importante à l'intérieur du boîtier et/ou qui présente en fonctionnement la température la plus importante parmi les composants électroniques de l'équipement électronique.

3. Equipement électronique selon la revendication 1, dans lequel la base et la partie courante sont formées de deux pièces distinctes fixées l'une à l'autre.

4. Equipement électronique selon l'une des revendications précédentes, dans lequel la partie courante du pied conducteur thermique comporte une pièce profilée.

5. Equipement électronique selon la revendication 1, dans laquelle les ailettes s'étendent dans des plans radiaux par rapport à un axe (X ; X') de la partie courante.

6. Equipement électronique selon l'une des revendications précédentes, dans lequel le pied conducteur thermique comporte une enveloppe plastique (17) qui le recouvre au moins partiellement.

7. Equipement électronique selon l'une des revendications précédentes, l'équipement électronique étant un décodeur pour une télévision.

## Patentansprüche

1. Elektronische Ausrüstung, umfassend:
- ein Gehäuse (2), das ein wärmeleitendes Chassis (4) umfasst;
- elektronische Bauelemente, die im Inneren des Gehäuses (2) integriert sind und ein elektronisches Bauelement umfassen, das direkt in Kontakt mit dem wärmeleitenden Chassis (4) angeordnet ist,
- einen wärmeleitenden Fuß (3; 20; 26) in Kontakt mit dem wärmeleitenden Chassis, wobei der wärmeleitende Fuß eine Basis und einen laufenden Teil umfasst, der sich vertikal zwischen der Basis und dem wärmeleitenden Chassis erstreckt, und Rippen, die im Inneren des laufenden Teils gebildet sind.

2. Elektronische Ausrüstung nach Anspruch 1, bei der das elektronische Bauelement, das direkt in Kontakt mit dem wärmeleitenden Chassis (4) angeordnet ist, ein heißestes elektronisches Bauelement ist, das die größte Wärmequelle im Inneren des Gehäuses ist und/oder das im Betrieb die höchste Temperatur unter den elektronischen Bauelementen der elektronischen Ausrüstung aufweist.

3. Elektronische Ausrüstung nach Anspruch 1, bei der die Basis und der laufende Teil aus zwei getrennten Teilen gebildet sind, die aneinander befestigt sind.

4. Elektronische Ausrüstung nach einem der vorhergehenden Ansprüche, bei dem der laufende Teil des wärmeleitenden Fußes ein Profilstück umfasst.

5. Elektronische Ausrüstung nach Anspruch 1, bei der sich die Rippen in radialen Ebenen in Bezug auf eine Achse (X; X') des laufenden Teils erstrecken.

6. Elektronische Ausrüstung nach einem der vorhergehenden Ansprüche, bei der der wärmeleitende Fuß eine Kunststoffhülle (17) umfasst, die ihn zumindest teilweise abdeckt.

7. Elektronische Ausrüstung nach einem der vorhergehenden Ansprüche, wobei die elektronische Ausrüstung ein Decoder für einen Fernseher ist.

## Claims

1. Electronic equipment comprising:
- a box (2) comprising a thermally-conductive chassis (4) ;
- electronic components incorporated inside the box (2) and including an electronic component placed in direct contact with the thermally-conductive chassis (4)
- a thermally-conductive stand (3; 20; 26) in contact with the thermally-conductive chassis, the thermally-conductive stand comprising a base and a leg that extends vertically between the base and the thermally-conductive chassis and fins which are formed inside the leg.

2. Electronic equipment according to claim 1, wherein the electronic component placed in direct contact with the thermally-conductive chassis (4) is a hottest electronic component that is the greatest source of heat inside the box and/or that, in operation, presents the highest temperature from among the electronic components of the electronic equipment.

3. Electronic equipment according to claim 1, wherein the base and the leg are constituted by two distinct parts that are fastened together.

4. Electronic equipment according to any preceding claim, wherein the leg of the thermally-conductive stand comprises a section member.

5. Electronic equipment according to claim 1, wherein the fins lie in planes that are radial relative to an axis (X; X') of the leg.

6. Electronic equipment according to any preceding claim, wherein the thermally-conductive stand includes a plastics covering (17) that covers it, at least in part.

7. Electronic equipment according to any preceding claim, the electronic equipment being a decoder for a television.
